# EUROPÄISCHE PATENTSCHRIFT

(11) **EP 0 918 592 B1**
(45) Veröffentlichungstag und Bekanntmachung des Hinweises auf die Patenterteilung: **19.02.2003**
(21) Anmeldenummer: 98933608.6
(22) Anmeldetag: 12.06.1998
(51) Int. Cl.: B23Q 3/157, H05K 13/04

(54) **FERTIGUNGS- UND/ODER MONTAGEVORRICHTUNG**
PRODUCTION AND/OR MOUNTING DEVICE
DISPOSITIF DE PREPARATION ET/OU DE MONTAGE

(30) Priorität: 21.06.1997 DE 19726374; 02.07.1997 DE 19728264; 05.08.1997 DE 19733774; 11.11.1997 DE 19749633
(43) Veröffentlichungstag der Anmeldung: 02.06.1999
(73) Patentinhaber: Feintool International Holding, 3250 Lyss (CH)
(72) Erfinder: Kumeth, Sigmund, 92280 Kastl (DE)
(74) Vertreter: Matschkur, Lindner Blaumeier Patent- und Rechtsanwälte
(86) Internationale Anmeldenummer: EP9803549
(87) Internationale Veröffentlichungsnummer: WO98058764

(56) Entgegenhaltungen:
- EP-A- 0 261 261
- DE-U- 9 401 884
- US-A- 5 575 059

## Beschreibung

Die Erfindung betrifft eine Fertigungs- und/oder Montagevorrichtung zum Fertigen und/oder Montieren eines Werkstücks, mit einem Vorrichtungsgestell mit einer Bewegungseinrichtung, an der mehrere Werkstückträger angeordnet sind, die bezüglich am Vorrichtungsgestell feststehend angeordneten Arbeitsmodulen und Zubringeinrichtungen getaktet bewegbar sind.

Solche Fertigungs- und/oder Montagevorrichtungen sind in Form von Rundtaktanlagen mit einem die Werkstückträger fördernden Drehteller als Bewegungseinrichtung wie auch als Lineartaktanlagen mit einer entsprechenden linearen, die Werkstückträger bewegenden Förderstrecke ausgebildet. Sie kommt überall dort zum Einsatz, wo maschinell in mehreren Fertigungs- oder Montagestufen ein Gegenstand herzustellen ist, beispielsweise bei der Herstellung elektrotechnischer oder elektromechanischer Bauteile, feinmechanischer Werkstücke oder auch im pharmazeutischen Bereich wie auch in der Automobilindustrie. Bei diesen Anlagen wird das Werkstück kontinuierlich zusammengesetzt oder hergestellt, wozu es getaktet zu den jeweiligen Arbeitsmodulen und Zubringeinrichtungen gebracht wird, welche einen der Arbeitsreihenfolge entsprechenden Arbeitsschritt durchführen beziehungsweise das der Arbeitsreihenfolge entsprechend erforderliche Bauteil oder dergleichen zubringen. Als Arbeitsmodule können hier beispielsweise Handlingeinrichtungen in Form von Zangen und Greifern zum Einsatz kommen, gleichermaßen sind auch Schraub-, Schweiß- oder Löteinrichtungen wie auch Präge- oder Druckeinrichtungen verwendbar. Bei der Zubringeinrichtung kann es sich beispielsweise um eine Bauteilfördereinrichtung handeln, gleichermaßen auch um eine Stapeleinheit oder ein Stanzband mit einer entsprechenden Stanzeinrichtung, um aus einem Bauteilband die erforderlichen Komponenten herauszustanzen, welche anschließend mit dem Arbeitsmodul zu verarbeiten sind. Dabei sind die Anlagen in ihrem Aufbau und Ausbildung einzig zur Fertigung desjenigen Werkstückes, für welches sie konzipiert wurden, ausgebildet, das heißt, sämtliche Komponenten sind entsprechend den jeweils durchzuführenden Arbeitsschritten beziehungsweise den zu verarbeitenden Teilen etc. gefertigt. Das heißt, daß für unterschiedliche Werkstücke jeweils eine separate Vorrichtung vorgesehen sein muß. Ein Umrüsten der bekannten Anlagen im Falle einer Änderung des Werkstückaufbaus oder dergleichen ist nicht oder nur mit großem Aufwand möglich. Für den Betreiber derartiger Anlagen bedeutet dies ein hohes Maß an Unflexibilität, da er hinsichtlich der herzustellenden Werkstücke weitgehend mit den vorhandenen Vorrichtungen festgelegt ist und im Falle einer Änderung der Werkstücke oder dergleichen eine neue Vorrichtung anschaffen oder unter hohen Investitionskosten die Umrüstung vornehmen muß. Dies gilt auch in dem Fall, daß ein Werkstück nicht mehr hergestellt wird und insoweit die Anlage nicht mehr betrieben wird.

Der Erfindung liegt somit das Problem zugrunde, eine Fertigungs- und/oder Montagevorrichtung anzugeben, welche ein schnelles und einfaches Umrüsten ohne großen Aufwand ermöglicht, so daß es möglich ist, bei entsprechenden Änderungen im Werkstück oder im Produktionsablauf oder dergleichen die Anlage sofort umstellen zu können, wie auch die Möglichkeit gegeben werden soll, eine Vorrichtung mühelos zur Fertigung/Montage eines anderen, neuen Werkstücks umzurüsten.

Zur Lösung diese Problems ist bei einer Fertigungs- und/oder Montagevorrichtung der eingangs genannten Art erfindungsgemäß vorgesehen, daß die Werkstückträger und die Arbeitsmodule und die Zubringeinrichtungen mittels für die Werkstückträger und die Arbeitsmodule und die Zubringeinrichtungen jeweils gleich ausgebildeten Wechselbefestigungseinrichtungen derart lösbar und austauschbar befestigt beziehungsweise befestigbar sind, daß zum Umrüsten der Vorrichtung lediglich das oder die zu verändernden Werkstückträger und Arbeitsmodule und Zubringeinrichtungen am eine Grundeinheit bildenden Vorrichtungsgestell auszutauschen sind.

Die erfindungsgemäße Vorrichtung ist modular aufgebaut bestehend aus einem standardisierten und für alle Vorrichtungen gleichen Vorrichtungsgestell, das eine Grundeinheit bildet, welche entsprechend auf- oder nachgerüstet wird. Die im Rahmen der Nachrüstung gegebenenfalls zu wechselnden Komponenten sind mit besonderem Vorteil mittels für die jeweilige Komponenten standardisierten Schnellwechselbefestigungseinrichtungen am Vorrichtungsgestell befestigbar. Im Bedarfsfall werden einfachst diese Wechselbefestigungseinrichtungen gelöst und infolge der Standardisierung dieser Befestigung das neue Element eingesetzt und befestigt, wonach dieser Umrüstungsschritt beendet ist. Am Vorrichtungsgestell selbst sind keinerlei Tätigkeiten vorzunehmen. Die erfindungsgemäße Vorrichtung ermöglicht also mit besonderem Vorteil sowohl bei Rundtakt- wie auch bei Lineartaktanlagen ein einfaches und schnelles Umrüsten ohne schwierige und komplizierte Umrüstarbeiten. Dieses System kann erfindungsgemäß auch bei der Befestigung einer Arbeitseinheit am Arbeitsmodul beziehungsweise einer Zubringeinheit an der Zubringeinrichtung zum Einsatz kommen, so daß auch diese Einheiten mühelos im Bedarfsfall ausgetauscht werden können.

Als vorteilhaft hat es sich erwiesen, wenn erfindungsgemäß die Wechselbefestigungseinrichtungen als Steck-Rast-Verbindung mit einem am Vorrichtungsgestell beziehungsweise der Bewegungseinrichtung, gegebenenfalls am Arbeitsmodul beziehungsweise der Zubringeinrichtung angeordneten ersten Teil und einem am Werkstückträger beziehungsweise dem Arbeitsmodul beziehungsweise der Zubringeinrichtung, gegebenenfalls der Arbeitseinheit beziehungsweise der Zubringeinheit angeordneten zweiten Teil ausgebildet sind, wobei sich hier als besonders vorteilhaft eine Schwalbenschwanzverbindung erwiesen hat. Diese Steck-Rast-Verbindung ermöglicht es mit besonderem Vorteil, das auszutauschende Element einfachst durch Lösen der Rastverbindung abzuziehen und das neue Element durch einfaches Einstecken und Verschieben bis zum Verrasten zu befestigen. Infolge dieser erfindungsgemäßen Ausbildung der Befestigungseinrichtung ist die richtige Positionierung stets vorgegeben. Nach Herstellen der Verbindung ist der jeweilige Umrüstungsschritt beendet. Insbesondere die Schwalbenschwanzverbindung läßt hier ein einfaches und sicheres Arbeiten zu. Als vorteilhaft hat es sich ferner erwiesen, wenn die Steck-Rast-Verbindung als selbsthemmende Verbindung ausgebildet ist, um ein unbeabsichtigtes Lösen der Verbindung zu vermeiden.

Erfindungsgemäß kann die Wechselbefestigungseinrichtung einen an einem Teil vorgesehenen, mittels eines Betätigungselements bewegbaren Rastzapfen und eine am anderen Teil ausgebildete Zapfenaufnahme umfassen. In einer einfachsten Ausführung kann hier der Rastzapfen als Steckzapfen mit einem entsprechenden Angriffsabschnitt ausgebildet sein, der beim Ineinanderschieben der Teile in die entsprechende Zapfenaufnahme eingesteckt wird. Besonders vorteilhaft jedoch ist es, wenn das Betätigungselement ein manuell gegen eine Rückstellkraft zu betätigender Druckbolzen ist, an welchem der Rastzapfen bewegungsgekoppelt gelagert ist. Die Bewegungskopplung kann erfindungsgemäß mittels eines am Rastzapfen vorgesehenen und in eine am Betätigungselement ausgebildete Führungsnut eingreifenden Lagerzapfens realisiert sein. Eine gleichermaßen wirkungsvolle und selbsthemmende Alternative kann vorsehen, daß die Bewegungskopplung mittels eines über einen Lagerzapfen am Betätigungselement gelagerten Kniehebels, dessen Enden am jeweiligen Teil beziehungsweise am Rastzapfen gelagert sind, gebildet ist.

Die Wechselbefestigungseinrichtung kann erfindungsgemäß ferner derart ausgebildet sein, daß das jeweilige zu befestigende Element in mehreren Befestigungspositionen positionierbar ist, wozu lediglich entsprechend mehrere Rastaufnahmen vorgesehen sein müssen. Dies schafft insbesondere beim Umrüsten auf neue Komponenten mehr Möglichkeiten hinsichtlich der Ausrichtung derselben. Dabei hat es sich besonderes zweckmäßig erwiesen, wenn an den Arbeitsmodulen und/oder den Zubringeinrichtungen Justiermittel zum Einrichten der Arbeitsmodule und/oder deren Arbeitseinheiten und/oder der Zubringeinrichtungen und/oder deren Zubringeinheiten vorgesehen sind, wobei diese Justiermittel vorteilhaft eine Verstellspindel zum Bewegen der Rastaufnahme umfassen. Bei dieser Ausführungsform kann die Rastaufnahme bewegt werden, wodurch sich das ganze jeweilige Element bezüglich des ersten Teils am Vorrichtungsgestell bewegen läßt. Dies ist insbesondere in dem Fall von Vorteil, wenn bei der Zubringeinrichtung lediglich die Zubringeinheit ausgetauscht wird, um auf diese Weise die Zubringeinheit der Abnehmerposition nachführen zu können, da die Abnehmer fest an der in diesem Fall nicht ausgetauschten Zubringeinrichtung angeordnet sind und das Oberteil bezüglich der Abnehmerposition nachgeschoben werden muß.

Als besonderes vorteilhaft im Hinblick auf einen einfachen Aufbau der erfindungsgemäßen Vorrichtung hat es sich erwiesen, wenn zumindest ein Teil der Arbeitsmodule und/oder ein Teil der Zubringeinrichtungen jeweils lösbar mit einem für die Arbeitsmodule und/oder Zubringeinrichtungen gemeinsamen Antrieb verbunden beziehungsweise verbindbar sind. Selbstverständlich ist alternativ hierzu ein jeweils komponenteneigener Antrieb, welcher über die elektronische Steuerungseinrichtung gesteuert werden kann, denkbar. Im Falle eines gemeinsamen Antriebs kann erfindungsgemäß vorgesehen sein, daß am Vorrichtungsgestell mehrere den jeweiligen Arbeitsmodulen beziehungsweise Zubringeinrichtungen zugeordnete, mit dem Antrieb gekoppelte Antriebskupplungen vorgesehen sind, mit welchen die Arbeitsmodule beziehungsweise die Zubringeinrichtungen lösbar verbindbar sind. Dabei kann erfindungsgemäß die den Zubringeinrichtungen zugeordneten Antriebskupplungen als Winkelgetriebe ausgebildet sein, an welche einfachst die Zubringeinrichtung mit ihrem entsprechenden Kupplungsteil angeschlossen wird. Im Falle der Arbeitsmodule können die Arbeitskupplungen gegebenenfalls mehrere über den Antrieb bewegbare Kupplungsaufnahmen, in oder an denen entsprechende Kupplungselemente der Arbeitsmodule festlegbar sind, umfassen. Bei diesen Kupplungsaufnahmen kann es sich beispielsweise um horizontal angeordnete hinterschnittene Kupplungsringe handeln, welche mittels des Antriebs vertikal bewegbar sind, und in welche die entsprechenden Kupplungselemente der Arbeitsmodule einfachst eingesteckt werden können.

Im Hinblick darauf, daß bei der erfindungsgemäßen Vorrichtung ein einfaches Auswechseln auch der Werkstückträger möglich ist, ist es selbstverständlich möglich, nur so viele Werkstückträger vorzusehen, wie tatsächlich Arbeitsschritte vorzunehmen sind. Das heißt, es sind Bereiche möglich, in denen keine Werkstückträger vorhanden sind. Hier hat es sich als vorteilhaft erwiesen, wenn mindestens ein feststehendes Sensorelement zur Erfassung der daran vorbeibewegten Werkstückträger vorgesehen ist, wobei der Betrieb der Arbeitsmodule und/oder der Zubringeinrichtungen in Abhängigkeit des Erfassungsergebnisses gesteuert wird. Dies kann derart sein, daß bei Erfassung eines fehlenden Werkstückträgers dessen arbeits- beziehungsweise bewegungstaktbezogene Position in der den Arbeitsbetrieb des Arbeitsmoduls beziehungsweise der Arbeitseinheit und/oder der Zubringeinrichtung beziehungsweise der Zubringeinheit steuernden Steuereinrichtung gespeichert wird und mit jedem Bewegungstakt der Arbeitsbetrieb des Arbeitsmoduls beziehungsweise der Arbeitseinheit und/oder der Zubringeinrichtung beziehungsweise der Zubringeinheit der nachfolgend zu erreichenden oder bereits erreichten Position unterbrochen wird. Dies geschieht dabei derart, daß lediglich in die pneumatische Bewegungssteuerung beispielsweise des Greifers oder der Zange oder aber der Zubringeinheit eingegriffen wird, und so die eigentliche Arbeitstätigkeit unterbrochen wird. Der eigentliche Bewegungsablauf beispielsweise des Arbeitsmoduls, welches zum Beispiel in Richtung der Zubringeinheit verfährt und wieder zurückkehrt, und welcher über den gemeinsamen Antrieb ohnehin zwangsgesteuert ist, wird dabei nicht unterbrochen. Auf diese Weise wird also erreicht, daß tatsächlich nur dort gearbeitet wird, wo es erforderlich ist.

Im Hinblick auf die Auswechselbarkeit insbesondere der Werkstückträger kann mitunter das Problem auftreten, daß ein Werkstückträger nicht vollständig eingerastet ist. Beim Bewegen der Werkstückträger kann dieser nun an einem Gestellteil oder dergleichen anstoßen. Ein Weiterbewegen würde im günstigsten Fall lediglich zur Zerstörung des Werkstückträgers führen. Um dem vorzubeugen kann erfindungsgemäß im Antriebsstrang zwischen dem Antrieb und der Bewegungseinrichtung für die Werkstückträger eine Sicherheitskupplung vorgesehen sein, die im Bedarfsfall, insbesondere bei Überschreiten eines vorgegebenen Drehmoments den Antriebsstrang trennt, wobei dieser eine Bremse nachgeschaltet ist, die bei getrennter Sicherheitskupplung die Bewegungseinrichtung blockiert. Dabei kann ein weiteres Sensorelement vorgesehen sein, welches kontinuierlich die Lage eines beweglichen Teils der Sicherheitskupplung erfaßt und mit der elektromagnetischen Bremse in Steuerverbindung steht, wobei die Steuerung der Bremse in Abhängigkeit des Erfassungsergebnisses erfolgt. Das heißt, die Bremse wird automatisch dann gelöst, wenn das bewegliche Teil wieder in der korrekten, einen fehlerfreien Arbeitsbetrieb zulassenden Position ist. Schließlich hat es sich als vorteilhaft erwiesen, wenn erfindungsgemäß ein die Werkstückträger automatisch austauschendes Wechselmagazin vorgesehen ist, welches in geeigneter Position am Vorrichtungsgestell angeordnet wird und das automatisch die "alten" Werkstückträger gegen die "neuen" Werkstückträger austauscht.

Schließlich betrifft die Erfindung desweiteren ein Fertigungs- und/oder Montagevorrichtungssystem, umfassend ein eine standardisierte Grundeinheit bildendes Vorrichtungsgestell mit einer bezüglich diesem bewegbaren Bewegungseinheit und mehrere, in ihrer Art und/oder Funktion unterschiedlich ausgebildete Werkstückträger und Arbeitsmodule und Zubringeinrichtungen, wobei die Werkstückträger an der Bewegungseinheit und die Arbeitsmodule und die Zubringeinrichtungen am Vorrichtungsgestell mittels Wechselbefestigungseinrichtungen lösbar anbringbar sind, wobei jede Wechselbefestigungseinrichtung ein an der Bewegungseinheit beziehungsweise dem Vorrichtungsgestell angebrachtes erstes Teil und ein an jedem Werkstückträger beziehungsweise Arbeitsmodul beziehungsweise jeder Zubringeinrichtung vorgesehenes zweites Teil umfaßt, und wobei die zweiten Teile aller Werkstückträger beziehungsweise Arbeitsmodule beziehungsweise Zubringeinrichtungen jeweils identisch ausgebildet sind, so daß sie an jedem beliebigen zugeordneten ersten Teil befestigbar sind. Entsprechend ist die Wechselbefestigungseinrichtung bezüglich der in Weiterbildung der Erfindung ebenfalls lösbar an den Arbeitsmodulen angeordneten Arbeitseinheiten wie der an der Zubringeinrichtung lösbar angeordneten Zubringeinheiten aufgebaut. Dieser Erfindungsteil schafft also ein komplettes Wechselsystem, das die Umrüstung einer vorhandenen Vorrichtung in jeder beliebigen Form ermöglicht.

Ein Werkstückträger, ein Arbeitsmodul sowie eine Zubringeinrichtung des erfindungsgemäßen Systems zeichnen sich jeweils dadurch aus, daß das an ihnen vorgesehene zweite Teil, mit dem an der Fertigungs- und/oder Montagevorrichtung vorgesehenen ersten Teil unter Bildung einer Steck-Rast-Verbindung lösbar verbindbar ist. Entsprechendes gilt für die Arbeits- und Zubringeinheiten. Weitere vorteilhafte Ausgestaltungen sind den Unteransprüchen zu entnehmen.

Die Wechselbefestigungseinrichtung zeichnet sich dadurch aus, daß sie als Steck-Rast-Verbindung mit einem ersten und einem zweiten Teil ausgebildet ist, umfassend einen an einem Teil vorgesehenen, mittels eines gegen eine Rückstellkraft bewegbaren Druckbolzens bewegbaren Rastzapfen und eine am anderen Teil vorgesehene Zapfenaufnahme, wobei die Bewegungskopplung zwischen Druckbolzen und Rastzapfen mittels eines am Rastzapfen vorgesehenen und in eine am Druckbolzen ausgebildete Führungsnut eingreifenden Lagerzapfens oder mittels eines über einen Lagerzapfen am Druckbolzen gelagerten Kniehebels, dessen Enden am jeweiligen Teil beziehungsweise am Rastzapfen gelagert sind, gebildet ist, wobei die Verbindung bevorzugt eine selbsthemmende Schwalbenschwanzverbindung ist.

Weitere Vorteile, Merkmale und Einzelheiten der Erfindung ergeben sich aus dem im folgenden beschriebenen Ausführungsbeispiel sowie anhand der Zeichnungen. Dabei zeigen:
- Fig. 1: eine Teilansicht, teilweise im Schnitt, einer erfindungsgemäßen Fertigungs- und/oder Montagevorrichtung in Form einer Rundtaktanlage,
- Fig. 2, 3, 4: Schnittansichten der erfindungsgemäßen Wechselbefestigungseinrichtung in unterschiedlichen Perspektiven,
- Fig. 5: eine Explosionsdarstellung der in Fig. 1 gezeigten Vorrichtung,
- Fig. 6: eine Teilschnittansicht eines an der Bewegungseinrichtung angeordneten Werkstückträgers mit einer Wechselbefestigungseinrichtung einer ersten Ausführungsform,
- Fig. 8: eine Teilschnittansicht mehrerer an einer Bewegungseinrichtung angeordneter Werkstückträger mit einer Wechselbefestigungseinrichtung gemäß einer zweiten Ausführungsform und
- Fig. 9: Prinzipskizzen einer selbsthemmenden Wechselbefestigungseinrichtung gemäß einer weiteren Ausführungsform.

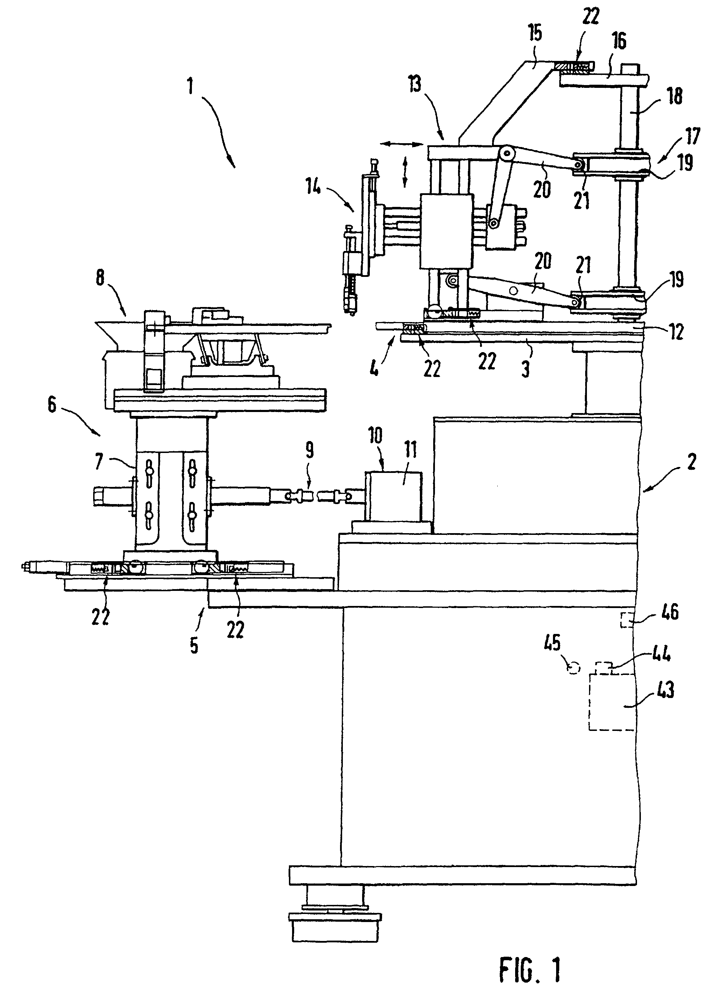

Fig. 1 zeigt in Form einer Teilansicht eine erfindungsgemäße Fertigungs- und/oder Montagevorrichtung. Diese besteht aus einem eine standardisierte Grundeinheit bildenden Vorrichtungsgestells 2, an dem integriert ein eine Bewegungseinrichtung 3 bildender Drehteller angeordnet ist. An diesem Drehteller, welcher über einen nicht gezeigten, im unteren Teil des Vorrichtungsgestells 2 angeordneten motorischen Antrieb z. B. in Form eines Kurvenscheibenantriebs rotierend antreibbar ist, sind randseitig mehrere Werkstückträger 4 angeordnet. An beziehungsweise in diesen Werkstückträgern 4 erfolgt die Fertigung/Montage des jeweiligen Werkstücks. Um dies zu ermöglichen sind an einer am Vorrichtungsgestell 2 vorgesehenen Befestigungsaufnahme 5 feststehend mehrere Zubringeinrichtungen 6 bestehend aus einem Unterbauteil 7 sowie einer Zubringeinheit 8 vorgesehen. Mit einer derartigen Zubringeinrichtung ist es möglich, am Werkstückträger 4 zu verbauende Bauteile in die entsprechende, für eine Weiterbearbeitung erforderliche Position zu bringen. Bei diesen Zubringeinrichtungen kann es sich beispielsweise um eine Fördereinrichtung wie im gezeigten Ausführungsbeispiel handeln, gleichermaßen kann sie auch als Stapeleinheit oder als Stanzeinrichtung zum Ausstanzen der Bauteile aus einem Stanzband ausgebildet sein. Im gezeigten Ausführungsbeispiel ist die Zubringeinrichtung 6 mittels einer lösbaren Antriebsverbindung 9 mit einer Antriebskupplung 10 in Form eines Winkelgetriebes 11, welches in Antriebsverbindung mit dem nicht gezeigten Antrieb steht, gekuppelt. Auf diese Weise wird die Zubringeinheit 8, die im gezeigten Beispiel die Gegenstände aus einer Vielzahl derselben aufnehmenden Aufnahme an die Abnahmepositition heranfördert, angetrieben.

An einem am Vorrichtungsgestell zwei angeordneten, oberhalb des Drehtellers befindlichen Aufbauteller 12 ist ein Arbeitsmodul 13 vorgesehen, an dem eine Arbeitseinheit 14, im gezeigten Beispiel ein Greifer, angeordnet ist. Mittels dieses bewegbaren Greifers (vgl. die beiden Doppelpfeile) ist es möglich, im Bereich der Abnahmposition an der Zubringeinheit 8 den angeförderten Gegenstand aufzunehmen, an den Werkstückträger 4 zu fördern und dort zu verbauen. Anstelle dieses ein Bauteilhandling zulassenden Arbeitsmoduls 13 kann das Arbeitsmodul auch als Schraub-, Löt- oder Schweißeinrichtung ausgebildet sein, welcher dann natürlich nicht unbedingt eine Zubringeinrichtung 6 zugeordnet sein muß. Auch eine Ausbildung aus Druck- oder Prägeeinrichtung ist möglich. Hier sind keinerlei Grenzen gesetzt. Das Arbeitsmodul 13 ist, wie beschrieben, bodenseitig am Aufbauteller 12 angeordnet. Mittels eines Trägers 15 ist das Arbeitsmodul 13 des weiteren an einem gestellseitig vorgesehenen Deckel 16 befestigt, was zu einer stabilen Anordnung führt. Die Bewegung des Arbeitsmoduls 13 mitsamt der Arbeitseinheit 14 in x- und y-Richtung erfolgt mittels einer Antriebseinrichtung 17. Diese besteht im gezeigten Beispiel aus einer Hubstange 18, welche mit dem nicht gezeigten motorischen Antrieb gekoppelt ist und die in vertikaler Richtung bewegt werden kann. An der Hubstange 18 sind im gezeigten Beispiel zwei Kupplungsaufnahmen 19 in Form von Hubtellern angeordnet, welche vertikal bewegbar sind. In diesen Kupplungsaufnahmen sind über Hebel 20 an dem Arbeitsmodul 13 angeordnete Kupplungselemente 21 bewegbar und lösbar aufgenommen. Bewegt sich nun die Hubstange 18 samt Kupplungsaufnahme 19 vertikal, so führt dies infolge der entsprechenden Hebelanordnung an dem Arbeitsmodul 13 dazu, daß dieses vertikal und horizontal bewegt wird, damit also auch die Arbeitseinheit 14. Die eigentliche Arbeitssteuerung der Arbeitseinheit 14 (wie auch gegebenenfalls bei entsprechender Ausgestaltung der Zubringeinrichtung 8) erfolgt über ein nicht gezeigtes pneumatisches System, welches also beispielsweise zum Öffnen und Schließen des Greifers oder dergleichen dient.

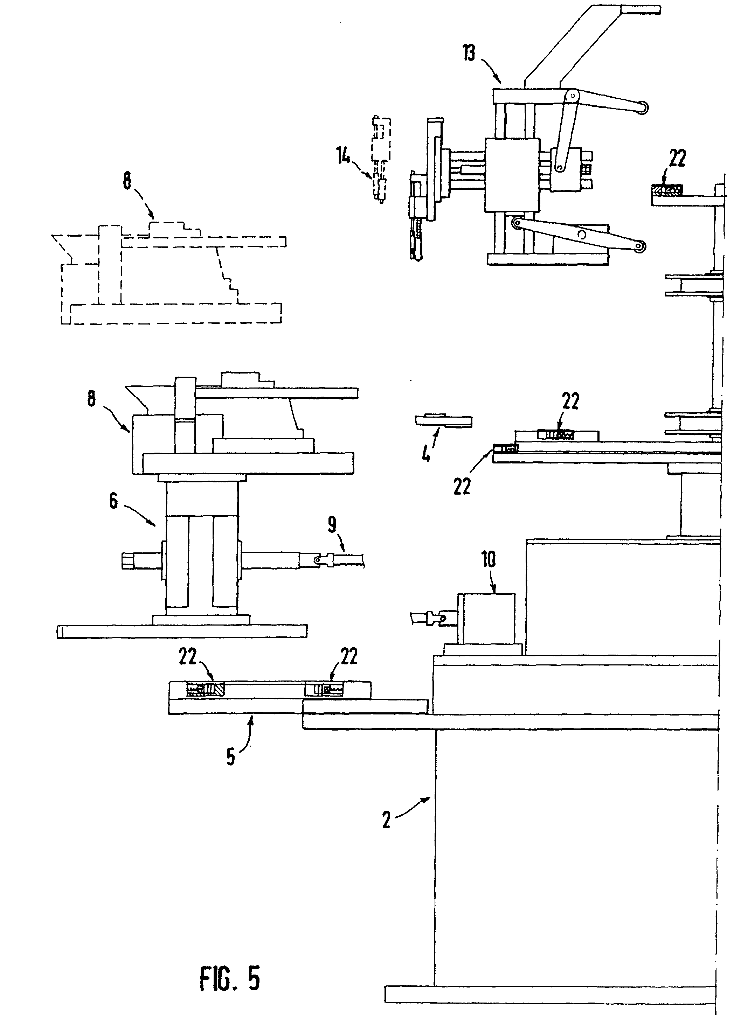

Wie in Fig. 1 gezeigt, ist der Werkstückträger 4, die Zubringeinrichtung 6 und das Arbeitsmodul 13 über Wechselbefestigungseinrichtungen 22, die nachfolgend noch näher beschrieben werden, lösbar am Vorrichtungsgestell 2 beziehungsweise an der Bewegungseinrichtung 3 angeordnet. Dies ermöglicht es, diese Komponenten mühelos durch einfaches Lösen dieser Wechselbefestigungseinrichtung 22, die als selbsthemmende Steck-Rast-Verbindung ausgebildet ist, vom Vorrichtungsgestell 2 zu trennen und an einer beliebigen, entsprechenden Befestigungseinrichtung wieder anzuordnen. Infolge des soweit standardisierten Aufbaus hinsichtlich der Befestigung der jeweiligen Komponenten am ebenfalls eine standardisierte Grundeinheit bildenden Vorrichtungsgestell ist es insoweit auch möglich, ein beliebiges anderes Arbeitsmodul beziehungsweise eine andere Zubringeinrichtung oder einen anderen Werkstückträger im Rahmen der Umrüstung der Vorrichtung zur Fertigung/Montage eines anders ausgebildeten Werkstücks anzubringen, wozu die jeweilige Komponente lediglich mittels der nachfolgend noch beschriebenen Wechelbefestigungseinrichtung anzubringen ist. Wie Fig. 5, in der die Lösbarkeit der jeweiligen Komponenten dargestellt ist, femer zeigt, ist es ebenfalls möglich (wenngleich nicht explizit dargestellt) die Zubringeinheit 8 sowie die Arbeitseinheit 14 ebenfalls mittels einer derartigen Wechselbefestigungseinrichtung lösbar und austauschbar zu lagern, so daß im Bedarfsfall nur noch diese Komponenten ausgetauscht werden müssen. Die Austauschbarkeit ist durch die gestrichelt dargestellte Zubringeinheit beziehungsweise Arbeitseinheit angedeutet.

Fig. 1 zeigt ferner prinzipiell die im Antriebsstrang integrierte Sicherheitskupplung 43. Sie umfaßt ein bewegliches Teil 44, welches bei Überschreiten eines bestimmten Drehmoments seine Position ändert, was von einem Sensorelement 45 erfaßt wird. Über dieses wird eine elektromagnetische Bremse 46 gesteuert, die sofort eingreift und ein Weiterbewegen verhindert.

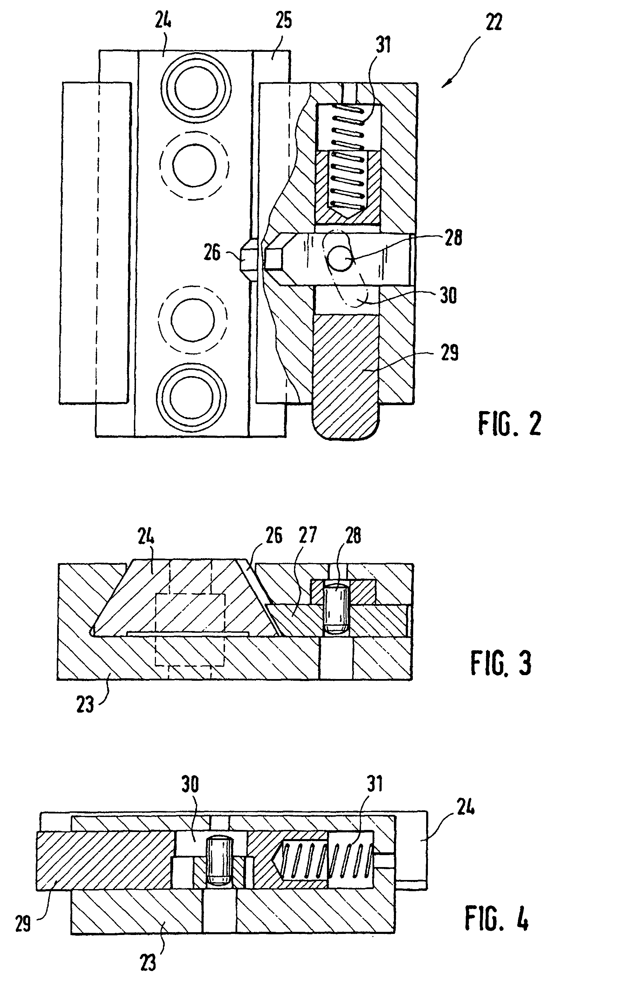

In den Figuren 2 bis 4 ist eine erfindungsgemäße Wechselbefestigungseinrichtung gezeigt, wobei hier das Grundprinzip dargestellt ist, wie es in soweit bei sämtlichen lösbaren Vorrichtungskomponenten zum Einsatz kommt. Die Wechselbefestigungeinrichtung 22 besteht aus einem ersten Teil 23, welches am Vorrichtungsgestell beziehungsweise an der Bewegungseinrichtung beziehungsweise im Bedarfsfall der Zubringeinrichtung und dem Arbeitsmodul angeordnet ist. In dieses einzusetzen ist ein zweites Teil 24, welches an der jeweiligen Komponente angeordnet ist. In den Figuren 2 bis 4 ist diese exemplarisch dargestellt. Beide Teile 23, 24 bilden miteinander eine Schwalbenschwanzverbindung, wie insbesondere aus Fig. 3 zu entnehmen ist. An der Schrägfläche 25 des zweiten Teils 24 ist eine Zapfenaufnahme 26 ausgebildet, in welche ein bewegbarer Rastzapfen 27, welcher an dem ersten Teil 23 angeordnet ist, einrasten kann. Der Rastzapfen 27 weist einen Lagerzapfen 28 auf, welcher in eine an einem Betätigungselement in Form eines Druckbolzens 29 ausgebildete Führungsnut 30 eingreift. Wie die Figuren 2 und 4 zeigen, ist der Druckbolzen 29 gegen eine Feder 31 beweglich gelagert. Zum Bewegen des Rastzapfens 27 im und aus seinem Eingriff mit der Zapfenaufnahme 26 ist der Druckbolzen 29 entsprechend zu betätigen. Wird bei eingerastetem Rastzapfen (entsprechend der Stellung in Fig. 2) der Druckbolzen 29 betätigt, so wandert infolge der Verschiebung der Führungsnut 30 der Lagerzapfen 28 in der Führungsnut. Diese ist etwas gebogen gestaltet, was dazu führt, daß der Rastzapfen senkrecht zur Bewegungsrichtung des Druckbolzens verschoben und aus seinem Eingriff mit der Rastaufnahme 26 gebracht wird. Die Federkraft der dabei komprimierten Feder 31 drängt den Druckbolzen 29 nach Lösen der Gegenkraft wieder in die Ausgangsstellung zurück, was dazu führt, daß auch der Rastzapfen 27 in Richtung des zweiten Teils 24 gedrängt wird. Die Führungsnut 30 in Verbindung mit dem Lagerzapfen 28 sind dabei derart angeordnet und ausgebildet, daß eine selbsthemmende Befestigung erzielt wird, da es insoweit nicht möglich ist, daß ohne Betätigen des Druckbolzens 29 der Rastzapfen aus seiner Eingriffsstellung unbeabsichtigt wandern kann, da der Lagerzapfen 28 von der Führungsnut 30 derart gegengelagert ist, daß ein Verschieben ohne Betätigen des Druckbolzens nicht möglich ist.

Soll nun eine der Komponenten der Vorrichtung ausgetauscht werden, wird lediglich die Rastverbindung durch Betätigen des Druckbolzens 29 gelöst, wonach das jeweils auszutauschende Teil einfach aus der Rastverbindung herausgezogen werden kann Das neue Bauteil wird in gleicher Weise einfachst durch Einschieben des zweiten Teils 24 in das erste Teil 23 eingesetzt und soweit verschoben, bis die beiden Rastelemente in Eingriff miteinander stehen. Dabei ist darauf hinzuweisen, daß das erste Bauteil 23, welches im gezeigten Beispiel einstückig ist, gleichermaßen auch zweistückig ausgebildet sein kann, derart, daß die die Schwalbenschwanzführung bewirkenden Teile des ersten Teils 23 separate Führungswinkel oder -schienen sind. Wie bereits ausgeführt kommt eine derartige Wechselbefestigungseinrichtung an den in Fig. 1 gezeigten Stellen zum Einsatz.

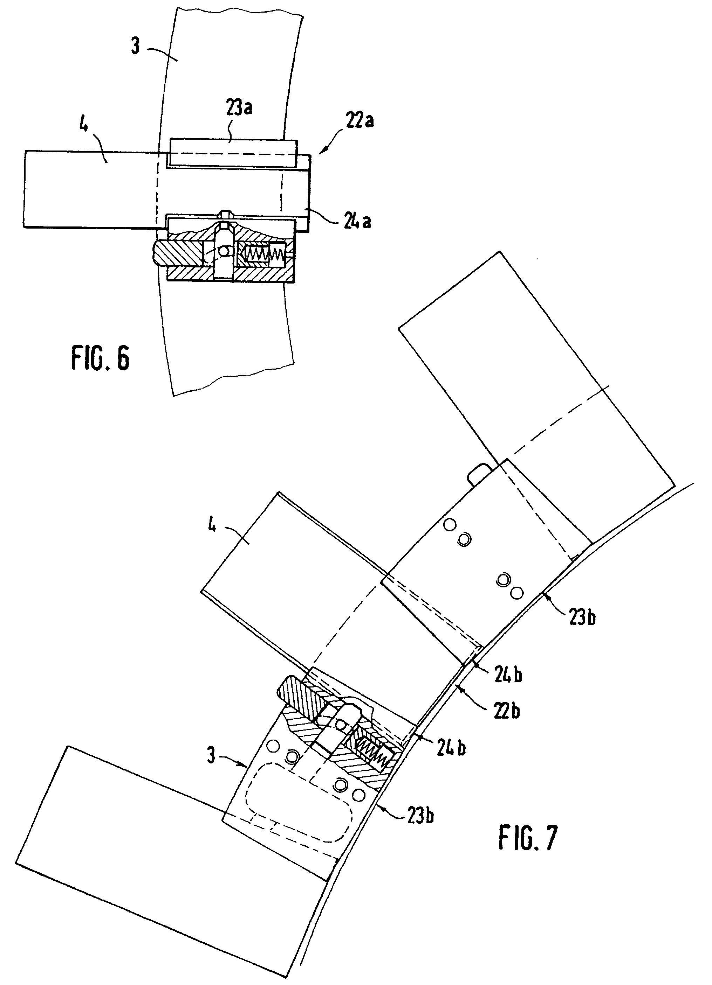

Die Figuren 6 und 7 zeigen zwei Beispiele, wie die Wechselbefestigungseinrichtung im Bereich der Werkstückträger ausgebildet sein kann. Fig. 6 zeigt eine erste Ausführungsform, wobei jedem Werkstückträger 4 eine separate Wechselbefestigungseinrichtung 22a zugeordnet ist. Diese ist wie bezüglich der Figuren 2 bis 4 beschrieben aufgebaut. Die Schrägflächen der beiden Teile 23a, 24a verlaufen im wesentlichen geradlinig, wobei hier das erste Teil 23a ein einstückiges Teil ist.

Anders die Modifikation (22b) gemäß Fig. 7. Dort sind die an der Bewegungseinrichtung 3 angeordneten ersten Teile 23b entsprechend länger ausgebildet. Jede Seitenkante bildet eine Führungsfläche für die Schwalbenschwanzverbindung. Das heißt, zwei nebeneinander geordnete erste Teile 23b bilden jeweils die einander gegenüberliegenden Führungsflächen. Zwischen diesen beiden Teile 23b ist der Werkstückträger 4 einzuschieben, bis er entsprechend verrastet. Die Ausbildung der Schwalbenschwanzverbindung verjüngt sich in diesem Fall in Richtung des Einschubendes des Werkstückträgers, das heißt, es wird insoweit auch eine Einschubbegrenzung realisiert, als die beiden Anlageflächen der Teile 23b, 24b bei hinreichend tiefem Einschieben aneinanderstoßen und nach Art einer Presspassung ein weiteres Einschieben verhindern.

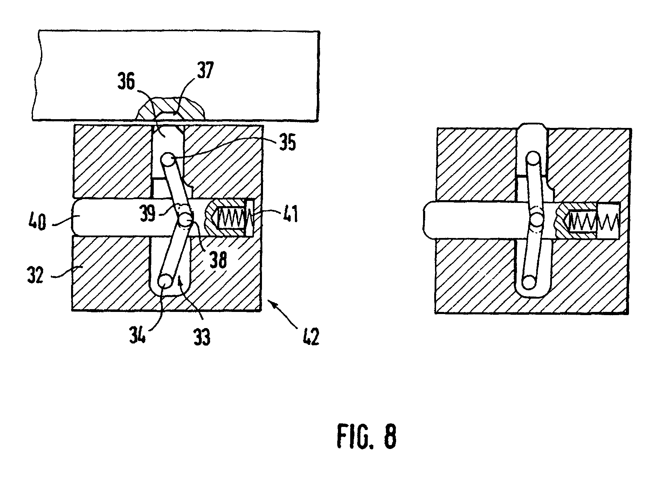

Schließlich zeigt Fig. 8 eine zweite Ausbildungsform einer erfindungsgemäßen selbsthemmenden Wechselbefestigungseinrichtung 42. Bei dieser kommt am ersten Teil 32 eine Kniehebelverbindung zum Einsatz. Diese besteht aus einem Kniehebel 33, welcher mit seinem einen Ende 34 am ersten Teil 32 und mit seinem anderen Ende 35 am Rastzapfen 36, welcher auch hier in eine entsprechende Rastaufnahme 37 eines einzusetzenden Elements eingreift, gelenkig befestigt ist. Mittig ist der Kniehebel mittels eines Lagerzapfens 38 in einer Durchbrechung 39 des Druckbolzens 40, welcher auch hier gegen eine Feder 41 bewegbar ist, gelagert. Die Arbeitsweise ist nun derart, daß bei Drücken des Druckbolzens 40 (ausgehend von der in Fig. 8 rechts gezeigten Position) die beiden Arme des Kniehebels 33 um den Lagerzapfen 38 verschwenkt werden, was dazu führt, daß der Rastzapfen 36 etwas nach innen gezogen wird, wobei zu diesem Zweck der Lagerzapfen 38 etwas in der Durchbrechung 39 beweglich ist. Der Bewegungsablauf läuft umgekehrt, wenn der Druckbolzen 40 entlastet wird.

Das erfindungsgemäße System beruht obigen Ausführungen zufolge einerseits auf dem Einsatz einer einfach zu bedienenden Schnellwechselbefestigungseinrichtung, und andererseits darauf, daß diese Schnellwechselbefestigungseinrichtungen für die jeweilige Komponentenart, die am Vorrichtungsgestell beziehungsweise der Bewegungseinrichtung oder aber an der Zubringeinrichtung oder dem Arbeitsmodul lösbar gelagert ist, in soweit identisch und standardisiert aufgebaut ist. Das heißt, ein neues Element besitzt ebenfalls die für dieses Element spezifische Befestigungskomponente, welche mit dem komplementären Befestigungsteil am Vorrichtungsgestell etc. kompatibel ist. Auf diese Weise ist eine einfache und beliebige Umrüstung möglich.

## Patentansprüche

1. Fertigungs- und/oder Montagevorrichtung zum Fertigen und/oder Montieren eines Werkstücks, mit einem Vorrichtungsgestell mit einer Bewegungseinrichtung, an der mehrere Werkstückträger angeordnet sind, die bezüglich am Vorrichtungsgestell feststehend angeordneten Arbeitsmodulen und Zubringeinrichtungen getaktet bewegbar sind, **dadurch gekennzeichnet, daß** die Werkstückträger (4) und die Arbeitsmodule (13) und die Zubringeinrichtungen (6) mittels für die Werkstückträger (4) und die Arbeitsmodule (13) und die Zubringeinrichtungen (6) jeweils gleich ausgebildeten Wechselbefestigungseinrichtungen (22, 22a, 22b, 42) derart lösbar und austauschbar befestigt bzw. befestigbar sind, daß zum Umrüsten der Vorrichtung lediglich das oder die zu verändernden Werkstückträger (4) und Arbeitsmodule (13) und Zubringeinrichtungen (6) am eine Grundeinheit bildenden Vorrichtungsgestell (2) auszutauschen sind.

2. Fertigungs- und/oder Montagevorrichtung nach Anspruch 1, wobei zumindest die Werkstückträger lösbar sind, **dadurch gekennzeichnet, daß** eine am jeweiligen Arbeitsmodul (13) vorgesehene Arbeitseinheit (14) und/oder eine an der jeweiligen Zubringeinrichtung (6) vorgesehene Zubringeinheit (8) mittels einer für die Arbeitseinheit (14) und/oder die Zubringeinheit (8) jeweils gleich ausgebildeten Wechselbefestigungseinrichtungen (22, 22a, 22b, 42) derart lösbar und austauschbar befestigt bzw. befestigbar sind, daß zum Umrüsten der Vorrichtung lediglich das oder die zu verändernden Arbeitseinheiten (14) und/oder Zubringeinheiten (8) auszutauschen sind.

3. Fertigungs- und/oder Montagevorrichtung nach Anspruch 1 oder 2, **dadurch gekennzeichnet, daß** die Wechselbefestigungseinrichtungen (22, 22a, 22b, 42) als Steck-Rast-Verbindung mit einem am Vorrichtungsgestell bzw. der Bewegungseinrichtung, gegebenenfalls am Arbeitsmodul bzw. der Zubringeinrichtung angeordneten ersten Teil (23, 23a, 23b, 32) und einem am Werkstückträger bzw. dem Arbeitsmodul bzw. der Zubringeinrichtung, gegebenenfalls der Arbeitseinheit bzw. der Zubringeinheit angeordneten zweiten Teil (24, 24a, 24b) ausgebildet sind.

4. Fertigungs- und/oder Montagevorrichtung nach Anspruch 3, **dadurch gekennzeichnet, daß** die Steck-Rast-Verbindung als Schwalbenschwanzverbindung ausgebildet ist.

5. Fertigungs- und/oder Montagevorrichtung nach Anspruch 3 oder 4, **dadurch gekennzeichnet, daß** die Steck-Rast-Verbindung als selbsthemmende Verbindung ausgebildet ist.

6. Fertigungs- undloder Montagevorrichtung nach einem der Ansprüche 3 bis 5, **dadurch gekennzeichnet, daß** die Wechselbefestigungseinrichtung (22, 22a, 22b, 42) einen an einem Teil (23, 23a, 23b, 32) vorgesehenen, mittels eines Betätigungselements bewegbaren Rastzapfen (27, 36) und eine am anderen Teil ausgebildete Zapfenaufnahme (26, 37) umfaßt.

7. Fertigungs- und/oder Montagevorrichtung nach Anspruch 6, **dadurch gekennzeichnet, daß** das Betätigungselement ein manuell gegen eine Rückstellkraft (31, 41) zu betätigender Druckbolzen (29, 40) ist, an welchem der Rastzapfen (27, 36) bewegungsgekoppelt gelagert ist.

8. Fertigungs- und/oder Montagevorrichtung nach Anspruch 6 oder 7, **dadurch gekennzeichnet, daß** die Bewegungskopplung mittels eines am Rastzapfen (26) vorgesehenen und in eine am Betätigungselement (29) ausgebildete Führungsnut (30) eingreifenden Lagerzapfens (28) oder mittels eines über einen Lagerzapfen (38) am Betätigungselement (40) gelagerten Kniehebels (33), dessen Enden am jeweiligen Teil bzw. am Rastzapfen gelagert sind, gebildet ist.

9. Fertigungs- und/oder Montagevorrichtung nach einem der vorangehenden Ansprüche, **dadurch gekennzeichnet, daß** die Wechselbefestigungseinrichtung derart ausgebildet ist, daß das jeweilige zu befestigende Element in mehreren Befestigungspositionen positionierbar ist.

10. Fertigungs- und/oder Montagevorrichtung nach einem der vorangehenden Ansprüche, **dadurch gekennzeichnet, daß** an den Arbeitsmodulen (13) und/oder den Zubringeinrichtungen (6) Justiermittel zum Einrichten der Arbeitsmodule (13) und/oder deren Arbeitseinheiten (14) und/oder der Zubringeinrichtungen (6) und/oder deren Zubringeinheiten (8) vorgesehen sind.

11. Fertigungs- und/oder Montagevorrichtung nach Anspruch 10, **dadurch gekennzeichnet, daß** die Justiermittel eine Verstellspindel zum Bewegen der Rastaufnahme umfassen.

12. Fertigungs- und/oder Montagevorrichtung nach einem der vorangehenden Ansprüche, **dadurch gekennzeichnet, daß** zumindest ein Teil der Arbeitsmodule (13) und/oder ein Teil der Zubringeinrichtungen (6) jeweils lösbar mit einem für die Arbeitsmodule (13) und/oder die Zubringeinrichtungen (6) gemeinsamen Antrieb verbunden bzw. verbindbar ist.

13. Fertigungs- und/oder Montagevorrichtung nach Anspruch 12, **dadurch gekennzeichnet, daß** am Vorrichtungsgestell (2) mehrere den jeweiligen Arbeitsmodulen (13) bzw. Zubringeinrichtungen (6) zugeordnete, mit dem Antrieb gekoppelte Antriebskupplungen vorgesehen sind, mit welchen die Arbeitsmodule (13) bzw. die Zubringeinrichtungen (6) lösbar verbindbar sind.

14. Fertigungs- und/oder Montagevorrichtung nach Anspruch 13, **dadurch gekennzeichnet, daß** die den Zubringeinrichtungen (6) zugeordneten Antriebskupplungen (10) als Winkelgetriebe (11) ausgebildet sind, und die den Arbeitsmodulen (13) zugeordneten Antriebskupplungen gegebenenfalls mehrere über den Antrieb bewegbare Kupplungsaufnahmen (19), in oder an denen entsprechende Kupplungselemente (21) der Arbeitsmodule (13) festlegbar sind, umfassen.

15. Fertigungs- und/oder Montagevorrichtung nach einem der vorangehenden Ansprüche, **dadurch gekennzeichnet, daß** mindestens ein feststehendes Sensorelement zur Erfassung der daran vorbeibewegbaren Werkstückträger vorgesehen ist, wobei der Betrieb der Arbeitsmodule und/oder der Zubringeinrichtungen in Anhängigkeit des Erfassungsergebnisses gesteuert wird.

16. Fertigungs- und/oder Montagevorrichtung nach Anspruch 15, **dadurch gekennzeichnet, daß** der Betrieb derart gesteuert wird, daß bei Erfassung eines fehlenden Werkstückträgers dessen arbeits- bzw. bewegungstaktbezogene Position in der den Arbeitsbetrieb des Arbeitsmoduls bzw. der Arbeitseinheit und/oder der Zubringeinrichtung bzw. der Zubringeinheit steuernden Steuerungseinrichtung gespeichert wird und mit jedem Bewegungstakt der Arbeitsbetrieb des Arbeitsmoduls bzw. der Arbeitseinheit und/oder der Zubringeinrichtung bzw. der Zubringeinheit der nachfolgend zu erreichenden oder bereits erreichten Position unterbrochen wird.

17. Fertigungs- und/oder Montagevorrichtung nach einem der vorangehenden Ansprüche, **dadurch gekennzeichnet, daß** im Antriebsstrang zwischen dem Antrieb und der Bewegungseinrichtung für die Werkstückträger eine Sicherheitskupplung (43) vorgesehen ist, die im Bedarfsfall, insbesondere bei Überschreiten eines vorgegebenen Drehmoments den Antriebsstrang trennt, und daß dieser nachgeschaltet eine Bremse (46) vorgesehen ist, die bei getrennter Sicherheitskupplung (43) die Bewegungseinrichtung (3) blockiert.

18. Fertigungs- und/oder Montagevorrichtung nach Anspruch 17, **dadurch gekennzeichnet, daß** ein Sensorelement (45) vorgesehen ist, welches kontinuierlich die Lage eines beweglichen Teils (44) der Sicherheitskupplung (43) erfaßt und mit der elektromagnetischen Bremse (46) in Steuerverbindung steht, wobei die Steuerung der Bremse (46) in Abhängigkeit des Erfassungsergebnisses erfolgt.

19. Fertigungs- und/oder Montagevorrichtung nach einem der vorangehenden Ansprüche, **dadurch gekennzeichnet, daß** ein die Werkstückträger automatisch austauschendes Wechselmagazin vorgesehen ist.

20. Fertigungs- und/oder Montagevorrichtungssystem, umfassend ein eine standardisierte Grundeinheit bildendes Vorrichtungsgestell mit einer bezüglich diesem bewegbaren Bewegungseinheit und mehrere, in ihrer Art und/oder Funktion unterschiedlich ausgebildete Werkstückträger und Arbeitsmodule und Zubringeinrichtungen, wobei die Werkstückträger an der Bewegungseinheit und die Arbeitsmodule und die Zubringeinrichtungen am Vorrichtungsgestell mittels Wechselbefestigungseinrichtungen lösbar anbringbar sind, wobei jede Wechselbefestigungseinrichtung ein an der Bewegungseinheit bzw. dem Vorrichtungsgestell angebrachtes erstes Teil und ein an jedem Werkstückträger bzw. Arbeitsmodul bzw. jeder Zubringeinrichtung vorgesehenes zweites Teil umfaßt, und wobei die zweiten Teile aller Werkstückträger bzw. Arbeitsmodule bzw. Zubringeinrichtungen jeweils identisch ausgebildet sind, so daß sie an jedem beliebigen zugeordneten ersten Teil befestigbar sind.

21. Fertigungs- und/oder Montagevorrichtungssystem nach Anspruch 20, **dadurch gekennzeichnet, dass** an den Arbeitsmodulen und/oder den Zubringeinrichtungen in ihrer Art und/oder Funktion unterschiedlich ausgebildete Arbeitseinheiten oder Zubringeinheiten mittels Wechselbefestigungseinrichtungen lösbar anbringbar sind, wobei jede Wechselbefestigungseinrichtung ein an jedem Arbeitsmodul bzw. jeder Zubringeinrichtung angebrachtes erstes Teil und ein an jeder Arbeitseinheit bzw. Zubringeinheit vorgesehenes zweites Teil umfaßt, und wobei die zweiten Teile aller Arbeitseinheiten bzw. Zubringeinheiten jeweils identisch ausgebildet sind, so daß sie an jedem beliebigen zugeordneten ersten Teil befestigbar sind.

22. Fertigungs- und/oder Montagevorrichtungssystem nach Anspruch 20 oder 21, **dadurch gekennzeichnet, daß** das am Werkstückträger und an dem Arbeitsmodul und an der Zubringeinrichtung vorgesehene zweite Teil mit dem ersten Teil unter Bildung einer Steck-Rast-Verbindung lösbar verbindbar ist.

23. Fertigungs- und/oder Montagevorrichtungssystem nach Anspruch 21 oder 22, **dadurch gekennzeichnet, dass** das an der Arbeitseinheit und/oder der Zubringeinheit vorgesehene zweite Teil mit dem ersten Teil unter Bildung einer Steck-Rast-Verbindung lösbar verbindbar ist.

24. Fertigungs- und/oder Montagevorrichtungssystem nach Anspruch 22 oder 23, **dadurch gekennzeichnet, daß** am zweiten Teil eine Zapfenaufnahme oder ein mittels eines Betätigungselements, insbesondere einem manuell gegen eine Rückstellkraft bewegbaren Druckbolzen betätigbarer Rastzapfen vorgesehen ist, welche oder welcher mit einem korrespondierenden Gegenstück am ersten Teil in Wirkungsverbindung bringbar sind.

25. Fertigungs- und/oder Montagevorrichtungssystem nach einem der Ansprüche 20 bis 24, **dadurch gekennzeichnet, daß** das zweite Teil als Gegenstück einer Schwalbenschwanzverbindung mit dem ersten Teil ausgebildet ist

26. Fertigungs- und/oder Montagevorrichtungssystem nach einem der Ansprüche 20 bis 25, **dadurch gekennzeichnet, dass** die Wechselbefestigungseinrichtung als Steck-Rast-Verbindung mit dem ersten (23, 23a, 23b, 42) und dem zweiten Teil (24, 24a, 24b) ausgebildet ist, umfassend einen an dem Teil vorgesehenen, mittels eines gegen eine Rückstellkraft (31, 41) bewegbaren Druckbolzens (29, 40) bewegbaren Rastzapfen (27, 36) und eine am anderen Teil vorgesehene Zapfenaufnahme (26, 37), wobei die Bewegungskopplung zwischen Druckbolzen (29, 40) und Rastzapfen (27, 36) mittels eines am Rastzapfen (27) vorgesehenen und in eine am Druckbolzen (29) ausgebildete Führungsnut (30) eingreifenden Lagerzapfens (28) oder mittels eines über einen Lagerzapfen (38) am Druckbolzen (40) gelagerten Kniehebels (33), dessen Enden am jeweiligen Teil (42) bzw. am Rastzapfen (36) gelagert sind, gebildet ist.

27. Fertigungs- und/oder Montagevorrichtungssystem nach Anspruch 26, **dadurch gekennzeichnet, dass** es eine selbsthemmende Verbindung ist.

## Claims

1. Manufacture and/or assembly apparatus for manufacturing and/or assembling a workpiece, having an apparatus frame with a moving device on which a plurality of tool holders are disposed, which are movable in a timed manner relative to working modules and feed devices disposed stationarily on the device frame, **characterised in that** the tool holders (4) and the working modules (13) and the feed devices (6) are fixed or fixable detachably and exchangeably by means of identically formed exchange fixings (22, 22a, 22b, 42) for the tool holders (4) and the working modules (13) and the feed devices (6) in such a manner that in order to retrofit the apparatus only the tool holders (4) and working modules (13) and feed devices (6) to be changed have to be exchanged on the device frame (2) forming a base unit.

2. Manufacture and/or assembly apparatus according to claim 1, wherein at least the tool holders are detachable, **characterised in that** a working unit (14) provided on the respective working module (13) and/or a feed unit (8) provided on the respective feed device (6) are so fixed or fixable in a detachable and exchangeable manner by means of a respective exchange fixing device (22, 22a, 22b, 42) formed identically in each case for the working unit (14) and the feed unit (8), in such a manner that in order to retrofit the apparatus only the working units (14) and/or feed devices (8) to be changed have to be exchanged.

3. Manufacture and/or assembly apparatus according to claim 1 or 2, **characterised in that** the exchange fixing devices (22, 22a, 22b, 42) are formed as a locating catch connection with a first part (23, 23a, 23b, 32) disposed on the apparatus frame or movement device, optionally on the working module or feed device and a second part (24, 24a, 24b) disposed on the workpiece holder or working module or feed device, optionally on the working unit or feed unit.

4. Manufacture and/or assembly apparatus according to claim 3, **characterised in that** the locating catch connection is formed as a dovetail connection.

5. Manufacture and/or assembly apparatus according to claim 3 or 4, **characterised in that** the locating catch connection is formed as a self-locking connection.

6. Manufacture and/or assembly apparatus according to one of claims 3 to 5, **characterised in that** the exchange fixing device (22, 22a, 22b, 42) comprises a catch (27, 36), provided on one part (23, 23a, 23b, 32) and movable by means of an actuating element, and a catch seat (26, 37) formed on the other part.

7. Manufacture and/or assembly apparatus according to claim 6, **characterised in that** the actuating element is a pressure bolt (29, 40) to be actuated manually against a restoring force (31, 41), on which bolt the catch (27, 36) is mounted with movable coupling.

8. Manufacture and/or assembly apparatus according to claim 6 or 7, **characterised in that** the movable coupling is formed by means of a journal (28) provided on the catch (26) and engaging in a guide groove (30) formed on the actuating element (29) or by means of a knee lever (33), which is mounted via a journal (38) on the actuating element (40) and whose ends are mounted on the respective part or on the catch.

9. Manufacture and/or assembly apparatus according to one of the preceding claims, **characterised in that** the exchange fixing device is so formed that the respective element to be fixed can be placed in various positions.

10. Manufacture and/or assembly apparatus according to one of the preceding claims, **characterised in that** on the working modules (13) and/or the feed devices (6), means are provided for aligning the working modules (13) and/or their working units (14) and/or the feed devices (6) and/or their feed devices (8).

11. Manufacture and/or assembly apparatus according to claim 10, **characterised in that** the alignment means comprise an adjustment spindle for moving the catch seat.

12. Manufacture and/or assembly apparatus according to one of the preceding claims, **characterised in that** at least some of the working modules (13) and/or some of the feed devices (6) are connected or are connectable detachably to a common drive for the working modules (13) and/or the feed modules (6).

13. Manufacture and/or assembly apparatus according to claim 12, **characterised in that** on the apparatus frame (2) a plurality of drive couplings coupled to the drive and allocated to the respective working modules (13) or feed units (6) are provided, to which the working modules (13) or the feed modules (6) are detachably connectable.

14. Manufacture and/or assembly apparatus according to claims 13, **characterised in that** the drive couplings (10) allocated to the feed devices (6) are formed as angular gears (11) and the drive couplings allocated to the working modules (13) optionally comprise a plurality of coupling seats (19) movable via the drive in or on the corresponding coupling elements (21) of the working module (13).

15. Manufacture and/or assembly apparatus according to one of the preceding claims, **characterised in that** at least one fixed sensor element is provided to detect the workpiece holders passing the same, wherein the operation of the working modules and/or of the feed devices is controlled according to the result of detection.

16. Manufacture and/or assembly apparatus according to claim 15, **characterised in that** operation is so controlled that upon detection of a missing workpiece holder whose position in the operating or movement cycle is stored in the control device controlling the operation of the working module or the working unit and/or of the feed device or feed unit and is interrupted with each movement cycle of the operation of the working module or of the working unit and/or the feed device or the feed unit of the next position to be reached or already reached.

17. Manufacture and/or assembly apparatus according to one of the preceding claims, **characterised in that** in the drive strand between the drive and the movement device for the workpiece holders a safety coupling (43) is provided, which in an emergency, in particular if a specified torque is exceeded, disconnects the drive strand, and **in that** downstream of this a brake (46) is provided, which locks the movement device (3) when the safety coupling (43) is disconnected.

18. Manufacture and/or assembly apparatus according to claim 17, **characterised in that** a sensor element (45) is provided which continuously detects the position of a moving part (44) of the safety coupling (43) and is in controlling connection with the electromagnetic brake (46) according to the result of detection.

19. Manufacture and/or assembly apparatus according to one of the preceding claims, **characterised in that** an exchange magazine automatically exchanging the workpiece holder is provided.

20. Manufacture and/or assembly apparatus system, comprising an apparatus frame forming a standard base unit with a movement unit movable relative to the said frame and a plurality of workpiece holders and working modules and feed devices which are differently formed in their type and function, wherein the workpiece holders are detachably mountable on the movement unit and the working modules and the feed devices on the apparatus frame by means of exchange fixing devices, wherein each exchange fixing device comprises a first part mounted on the movement unit or apparatus frame and a second part provided on each workpiece holder or working module or each feed device, and wherein the second parts of all workpiece holders or working modules or feed devices are each identically formed, so that they are fixable to any associated first part.

21. Manufacture and/or assembly apparatus system according to claim 20, **characterised in that** on the working modules and/or feed devices, working units or feed units which are different in their type and/or function are detachably mountable by means of exchange fixing devices, wherein each exchange fixing device comprises a first part mounted on each working module or each feed device and a second part provided on each working unit or feed unit, and wherein the second parts of all working units or feed units are each identically formed, so that they are fixable to any associated first part.

22. Manufacture and/or assembly apparatus system according to claim 20 or 21, **characterised in that** the second part provided on the workpiece holder and on the working module and on the feed device is detachably connectable to the first part, forming a locating catch connection..

23. Manufacture and/or assembly apparatus system according to claim 21 or 22, **characterised in that** the second part provided on the working unit and/or on the feed unit is detachably connectable to the first part, forming a locating catch connection.

24. Manufacture and/or assembly apparatus system according to claim 22 or 23, **characterised in that** on the second part a peg seat or catch peg actuatable by means of an actuating element, in particular a pressure bolt movable manually against a restoring force, is provided, which are capable of being brought into active connection with a corresponding counter-member on the first part.

25. Manufacture and/or assembly apparatus system according to one of claims 20 to 24, **characterised in that** the second part is formed as a counter-member of a dovetail connection with the first part.

26. Manufacture and/or assembly apparatus system according to one of claims 20 to 25, **characterised in that** the exchange fixing device is formed as a locating catch connection with the first (23, 23a, 23b, 42) and the second part (24, 24a, 24b), comprising a catch peg (27, 36) provided on the part and movable by means of a pressure bolt (29, 40) movable against a restoring force (31, 41), wherein the movement coupling between the pressure bolt (29, 40) and the catch (27, 36) is formed by means of a journal (28) provided on the catch (27) and engaging in a guide groove (30) formed on the pressure bolt (29) or by means of a knee lever (33), which is mounted via a journal (38) on the pressure bolt (40) and whose ends are mounted on the respective part (42) or on the catch (36).

27. Manufacturing and/or assembly apparatus system according to claim 26, **characterised in that** it is a self-locking connection.

## Revendications

1. Dispositif de préparation et/ou de montage pour préparer et/ou monter une pièce à usiner, avec un châssis de dispositif présentant un manipuleur, au niveau duquel sont disposés plusieurs supports de pièces à usiner, qui peuvent être déplacés de manière synchronisée par rapport à des modules de travail et des installations d'alimentation qui sont disposés de manière fixe au niveau du châssis du dispositif, **caractérisé en ce que** les supports de pièces à usiner (4), les modules de travail (13) et les installations d'alimentation (6) sont fixés, et peuvent être fixés pour être amovibles et remplaçcables, à l'aide d'installations de fixation interchangeables (22, 22a, 22b, 42) présentant chaque fois la même configuration pour les supports de pièces à usiner (4), les modules de travail (13) et les installations d'alimentation (6), de telle sorte que, pour réajuster le dispositif, seul(s) le ou les supports de pièces à usiner (4), modules de travail (13) et installations d'alimentation (6) à changer doivent être remplacés au niveau du châssis du dispositif (2) constituant une unité de base.

2. Dispositif de préparation et/ou de montage selon la revendication 1, dans lequel au moins les supports de pièces à usiner sont amovibles, **caractérisé en ce qu'**une unité de travail (14) prévue au niveau de du module de travail (13) respectif et/ou une unité d'alimentation (8) prévue au niveau de l'installation d'alimentation (6) respective sont fixées, ou peuvent être fixées de manière amovible ou interchangeable à l'aide d'installations de fixation interchangeables (22,22a, 22b, 42) présentant chaque fois la même configuration pour l'unité de travail (14) et/ou l'unité d'alimentation (8), de telle sorte que, pour réajuster le dispositif, seule(s) la ou les unités de travail (14) et/ou unités d'alimentation à changer (8) doivent être remplacées.

3. Dispositif de préparation et/ou de montage selon la revendication 1 ou 2, **caractérisé en ce que** les installations de fixation interchangeables (22, 22a, 22b, 42) sont configurées sous la forme d'un raccord par emboîtement avec un premier élément (23, 23a, 23b, 32) disposé au niveau du châssis du dispositif ou de l'installation de déplacement, le cas échant au niveau du module de travail ou de l'installation d'alimentation, et un deuxième élément (24, 24a, 24b) disposé au niveau du support de pièces à usiner ou du module de travail ou de l'installation d'alimentation, le cas échant de l'unité de travail ou de l'unité d'alimentation.

4. Dispositif de préparation et/ou de montage selon la revendication 3, **caractérisé en ce que** le raccord par emboîtement est configuré sous la forme d'un raccord en queue d'aronde.

5. Dispositif de préparation et/ou de montage selon la revendication 3 ou 4, **caractérisé en ce que** le raccord par emboîtement est configuré sous la forme d'un raccord autobloquant.

6. Dispositif de préparation et/ou de montage selon l'une quelconque des revendications 3 à 5, **caractérisé en ce que** l'installation de fixation interchangeable (22, 22a, 22b, 42) comprend un tenon (27, 36) pouvant se déplacer à l'aide d'un élément d'actionnement, prévus au niveau d'un élément (23, 23a, 23b, 32), et un logement pour le tenon (26, 37) configuré au niveau de l'autre élément.

7. Dispositif de préparation et/ou de montage selon la revendication 6, **caractérisé en ce que** l'élément d'actionnement est un axe d'appui (29, 40) à actionner manuellement en s'opposant à une force de rappel (31, 41), au niveau duquel le tenon d'arrêt (27, 36) est placé en étant couplé pour se déplacer.

8. Dispositif de préparation et/ou de montage selon la revendication 6 ou 7, **caractérisé en ce que** le couplage pour le déplacement est formé à l'aide d'un goujon (28) prévu au niveau du tenon d'arrêt (26) et s'accrochant dans une rainure de guidage (30) configurée au niveau de l'élément d'actionnement (29), ou à l'aide d'un levier coudé (33) disposé sur un goujon (28) au niveau de l'élément d'actionnement (40), dont les extrémités sont disposées au niveau de l'élément respectif ou au niveau du tenon d'arrêt.

9. Dispositif de préparation et/ou de montage selon l'une quelconque des revendications précédentes, **caractérisé en ce que** l'installation de fixation interchangeable est configurée de telle sorte que l'élément respectif à fixer peut être positionné dans plusieurs positions de fixation.

10. Dispositif de préparation et/ou de montage selon l'une quelconque des revendications précédentes, **caractérisé en ce que**, au niveau des modules de travail (13) et/ou des installations d'alimentation (6), sont prévus des moyens d'ajustage pour installer les modules de travail (13) et/ou leurs unités de travail (14) et/ou des installations d'alimentation (6) et/ou leurs unités d'alimentation (8).

11. Dispositif de préparation et/ou de montage selon la revendication 10, **caractérisé en ce que** les moyens d'ajustage comprennent une tige de réglage pour déplacer le logement du tenon.

12. Dispositif de préparation et/ou de montage selon l'une quelconque des revendications précédentes, **caractérisé en ce qu'**au moins un élément des modules de travail (13) et/ou un élément des installations d'alimentation (6) est raccordé, ou peut être raccordé respectivement de manière amovible, à un entraînement commun pour les modules de travail (13) et/ou les installations d'alimentation (6).

13. Dispositif de préparation et/ou de montage selon la revendication 12, **caractérisé en ce que**, au niveau du châssis du dispositif (2), il est prévu plusieurs couplages d'entraînement couplés à l'entraînement, affectés aux modules de travail (13) ou installations d'alimentation (6) respectifs auxquels peuvent être reliés de manière amovible les modules de travail (13) ou les installations d'alimentation (6).

14. Dispositif de préparation et/ou de montage selon la revendication 13, **caractérisé en ce que** les couplages d'entraînement (10) affectés aux installations d'alimentation (6) sont configurés sous la forme d'engrenages coniques (11), et comprennent les couplages d'entraînement affectés aux modules de travail (13), le cas échéant plusieurs logements de couplage (19) pouvant se déplacer par l'intermédiaire de l'entraînement, dans lesquels ou au niveau desquels les éléments de couplage (21) correspondants des modules de travail (13) peuvent être fixés.

15. Dispositif de préparation et/ou de montage selon l'une quelconque des revendications précédentes, **caractérisé en ce qu'**au moins un élément de détection fixe est prévu pour repérer les supports de pièces à usiner qui se déplacent devant, moyennant quoi le fonctionnement des modules de travail et/ou des installations d'alimentation est commandé en fonction du résultat du repérage.

16. Dispositif de préparation et/ou de montage selon la revendication 15, **caractérisé en ce que** le fonctionnement est commandé de telle sorte que, lorsqu'on repère l'absence d'un support de pièces à usiner, sa position liée au cycle de travail ou de déplacement est enregistrée dans l'installation de commande gérant l'opération de travail du module de travail ou de l'unité de travail et/ou de l'installation d'alimentation ou de l'unité d'alimentation, et est interrompue avec chaque cycle de déplacement de l'opération de travail du module de travail ou de l'unité de travail et/ou de l'installation d'alimentation ou de l'unité d'alimentation de la position suivante à atteindre ou de la position déjà atteinte.

17. Dispositif de préparation et/ou de montage selon l'une quelconque des revendications précédentes, **caractérisé en ce que**, dans la section d'entraînement entre l'entraînement et l'installation de déplacement pour le support de pièces à usiner, il est prévu un couplage de sécurité (43), qui sépare la section d'entraînement, en cas de besoin, notamment lors du dépassement d'un couple prédéterminé, et **en ce que**, en aval de celle-ci est prévu un frein (46), qui bloque l'installation de déplacement (3) au cas où le couplage de sécurité (43) est séparé.

18. Dispositif de préparation et/ou de montage selon la revendication 17, **caractérisé en ce qu'**il est prévu un élément de détection (45) qui repère de manière continue la situation d'un élément mobile (44) du couplage de sécurité (43), et qui est lié, en termes de commande, au frein électromagnétique (46), moyennant quoi la commande du frein (46) est réalisée en fonction du résultat du repérage.

19. Dispositif de préparation et/ou de montage selon l'une quelconque des revendications précédentes, **caractérisé en ce qu'**il est prévu un magasin de chargement remplaçant automatiquement le support de pièces à usiner.

20. Dispositif de préparation et/ou de montage, comprenant un châssis de dispositif constituant une unité de base standard, avec une unité de déplacement pouvant se déplacer par rapport à celle-ci, et plusieurs supports de pièces à usiner, modules de travail et installations d'alimentation configurés de manière différente quant à leur type et/ou leur fonction, moyennant quoi les supports de pièces à usiner peuvent être apposés de manière amovible au niveau de l'unité de déplacement, et les modules de travail et installations d'alimentation peuvent être apposés de manière amovible au niveau du châssis du dispositif à l'aide d'installations de fixation interchangeables, moyennant quoi chaque dispositif de fixation interchangeable comprend un premier élément apposé au niveau de l'unité de déplacement ou au niveau du châssis du dispositif, et un deuxième élément prévu au niveau de chaque support de pièces à usiner ou module de travail ou au niveau de chaque installation d'alimentation, et moyennant quoi les deuxièmes éléments de tous les supports de pièces à usiner ou modules de travail ou installations d'alimentation présentent chaque fois une configuration identique, de telle sorte qu'ils puissent être fixés à chaque premier élément souhaité qui leur est affecté.

21. Dispositif de préparation et/ou de montage selon la revendication 20, **caractérisé en ce que**, au niveau des modules de travail et/ou des installations d'alimentation, on peut apposer des unités de travail ou unités d'alimentation présentant une configuration différente selon leur type ou leur fonction à l'aide d'installations de fixation interchangeables, moyennant quoi chaque installation de fixation interchangeable comprend un premier élément apposé au niveau de chaque module de travail ou de chaque installation d'alimentation, et un deuxième élément prévu au niveau de chaque unité de travail ou unité d'alimentation, et moyennant quoi les deuxièmes éléments de toutes les unités de travail ou unités d'alimentation présentent chaque fois une configuration identique, de telle sorte qu'ils puissent être fixés à chaque premier élément souhaité qui leur est affecté.

22. Dispositif de préparation et/ou de montage selon la revendication 20 ou 21, **caractérisé en ce que** le deuxième élément prévu au niveau du support de pièces à usiner et au niveau du module de travail et de l'installation d'alimentation peut être relié de manière amovible avec le premier élément en formant un raccord par emboîtement.

23. Dispositif de préparation et/ou de montage selon la revendication 21 ou 22, **caractérisé en ce que** le deuxième élément prévu au niveau de l'unité de travail et/ou de l'unité d'alimentation peut être relié de manière amovible avec le premier élément en formant un raccord par emboîtement.

24. Dispositif de préparation et/ou montage selon la revendication 22 ou 23, **caractérisé en ce que**, au niveau du deuxième élément, il est prévu un logement de tenon ou un tenon d'arrêt pouvant être actionné à l'aide d'un élément d'actionnement, notamment un axe d'appui pouvant être déplacé manuellement en s'opposant à une force de rappel, lequel peut être mis en contact par action avec son pendant au niveau du premier élément.

25. Dispositif de préparation et/ou de montage selon l'une quelconque des revendications 20 à 24, **caractérisé en ce que** le deuxième élément est configuré sous la forme du pendant d'un raccord en queue d'aronde avec le premier élément.

26. Dispositif de préparation et/ou de montage selon l'une quelconque des revendications 20 à 25, **caractérisé en ce que** l'installation de fixation interchangeable est configurée sous la forme d'un raccord par emboîtement avec le premier élément (23, 23a, 23b, 42) et le deuxième élément (24, 24a, 24b), comprenant un tenon d'arrêt (27, 36) prévu au niveau d'un élément, qui peut être déplacé à l'aide d'une tige d'appui (29, 40) pouvant se déplacer en s'opposant à une force de rappel (31, 41), et un logement pour le tenon (26, 27) configuré au niveau de l'autre élément, moyennant quoi le couplage pour le déplacement entre les tiges d'appui (29, 40) et le tenon d'arrêt (27, 36) est réalisé à l'aide d'un goujon (28) prévu au niveau du tenon d'arrêt (27) et s'accrochant dans une rainure de guidage (30) configurée au niveau de la tige d'appui (29), ou à l'aide d'un levier coudé (33) disposé sur un goujon (28) au niveau de la tige d'appui (40), dont les extrémités sont disposées sur l'élément respectif (42) ou au niveau du tenon d'arrêt (36).

27. Dispositif de préparation et/ou de montage selon la revendication 26, **caractérisé en ce qu'**il s'agit d'un raccord autobloquant.
